# EUROPEAN PATENT APPLICATION

(11) **EP 4 672 308 A1**
(43) Date of publication of application: **31.12.2025**
(21) Application number: 24184065.1
(22) Date of filing: 24.06.2024
(51) Int. Cl.: H01L 21/67, H01L 21/673

(54) **SUBSTRATE STORAGE SYSTEM, SUBSTRATE HANDLING APPARATUS, METHOD OF TEMPORARILY STORING A SUBSTRATE**

(71) Applicant: ASML Netherlands B.V., 5500 AH Veldhoven (NL)
(72) Inventor: BRULS, Richard Joseph, 5500 AH Veldhoven (NL)
(74) Representative: ASML Netherlands B.V.

(57) **Abstract**

The invention relates to a substrate storage system comprising an enclosure, a substrate loading port to load a substrate into and/or unload a substrate from a loading position within the enclosure, and a substrate holder to hold a substrate within the enclosure. The substrate holder is configured to move the substrate between the loading position and at least one storage position spaced from the loading position. The substrate storage system further comprises a purging system to mainly purge the substrate when located in the loading position, and wherein the at least one storage position is a mainly non-purged space.

## Description

### FIELD

The present invention relates to a substrate storage system, a substrate handling apparatus, A method of temporarily storing a substrate in the substrate storage system, and a method comprising projecting a patterned beam of radiation onto a substrate.

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern at a patterning device (e.g., a mask) onto a layer of radiation-sensitive material (resist) provided on a substrate.

To project a pattern on a substrate a lithographic apparatus may use electromagnetic radiation. The wavelength of this radiation determines the minimum size of features which can be formed on the substrate. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

The wavelength of radiation used by a lithographic apparatus to project a pattern onto a substrate determines the minimum size of features which can be formed on that substrate. A lithographic apparatus which uses EUV radiation, being electromagnetic radiation having a wavelength within the range 4-20 nm, may be used to form smaller features on a substrate than a conventional lithographic apparatus (which may for example use electromagnetic radiation with a wavelength of 193 nm).

The maximum area of the patterning device that may be imaged onto the substrate using the lithographic apparatus (i.e. the maximum image area) may vary between different lithographic apparatus. For example, some lithographic apparatus may only be capable of imaging an area of the patterning device that is less than or equal to half of the maximum image area of other lithographic apparatus. A technique known as stitching may be used to overcome the limited maximum image area of some lithographic apparatus. Stitching includes performing at least two sub-exposures on neighboring areas of a substrate to form a combined image on the substrate. After a lithographic exposure is performed the substrate undergoes resist processing which includes, for example, a baking process. In the case of a stitched exposure, the baking process is postponed until each set of sub-exposures have taken place across all target areas of the substrate. A plurality of substrates that are to be lithographically processed as a group may be referred to as a lot. Delays may arise between performing the first set of sub-exposures of the first substrate of a lot and performing a subsequent set of sub-exposures of the final substrate of the lot. Lithographically exposed resist on the substrate may be vulnerable to degradation during such delays.

In an embodiment of a lithographic system, a substrate storage system is provided to temporarily store substrates between two sub-exposures. In this embodiment, a purging system is provided to purge substrates in the substrate storage system. This purging system has a relative high gas consumption, resulting in a relatively low purging performance with respect to the quantity of purging gas used. The relatively high purging gas consumption may also contribute to a higher cost of ownership.

It is desirable to provide, for example, a substrate storage system and method that obviates or mitigates one or more problems of the prior art, whether identified herein or elsewhere.

### SUMMARY

It is an aim of the invention to provide a substrate storage system to temporarily store one or more substrates, wherein the substrate storage system is configured to more efficiently purge a substrate in the substrate storage system. More generally, it is an aim of the invention to provide an improved substrate storage system.

According to an aspect of the invention there is provided a substrate storage system comprising:
an enclosure;
a substrate loading port to load a substrate into and/or unload a substrate from a loading position within the enclosure,
a substrate holder to hold a substrate within the enclosure, wherein the substrate holder is configured to move the substrate between the loading position and at least one storage position spaced from the loading position,
a purging system to mainly purge the substrate when located in the loading position, and
wherein the at least one storage position is a mainly non-purged space.

According to an aspect of the invention there is provided a substrate handling apparatus comprising such substrate storage system.

According to an aspect of the invention there is provided a method of temporarily storing a substrate in a substrate storage system, comprising the steps of:
loading the substrate through the substrate loading port in the loading position onto the substrate holder,
moving the substrate holder to arrange the substrate in the at least one storage position,
moving the substrate holder to arrange the substrate back in the loading position,

unloading the substrate through the substrate loading port from the loading position,
wherein the method comprises during at least loading and unloading of the substrate mainly purging of the substrate in the loading position, and
wherein the method comprises mainly non-purging of the substrate in the storage position.

According to an aspect of the invention there is provided a method comprising projecting a patterned beam of radiation onto a substrate, comprising the steps of:
carrying out a first projecting step of projecting a patterned beam of radiation onto the substrate, wherein the patterned beam of radiation is patterned with a first patterning device,
temporarily storing the substrate in a substrate storage system, and
carrying out a second projecting step of projecting a patterned beam of radiation onto the substrate, wherein the patterned beam of radiation is patterned with a second patterning device.

### BRIEF DESCRIPTION OF THE DRAWINGS

Embodiments of the invention will now be described, by way of example only, with reference to the accompanying schematic drawings, in which:
Fig. 1 schematically depicts a lithographic system comprising a lithographic apparatus, a radiation source and a substrate storage system;
Fig. 2 schematically depicts a maximum image area of a first lithographic apparatus compared with two maximum image areas of a second lithographic apparatus;
Fig. 3 schematically depicts a view from above a portion of a lithographic apparatus having a substrate storage system;
Figs. 4 and 5 schematically depict an embodiment of a substrate storage system; and
Fig, 6 schematically depicts locations of loading position and storage positions in the substrate storage system of Fig's. 4 and 5; and

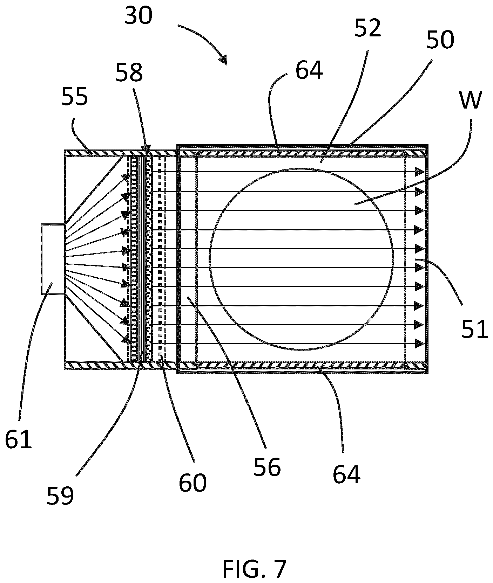

Fig. 7 schematically depicts a top view on the loading position of the substrate storage system of Figures 4 and 5.

### DETAILED DESCRIPTION

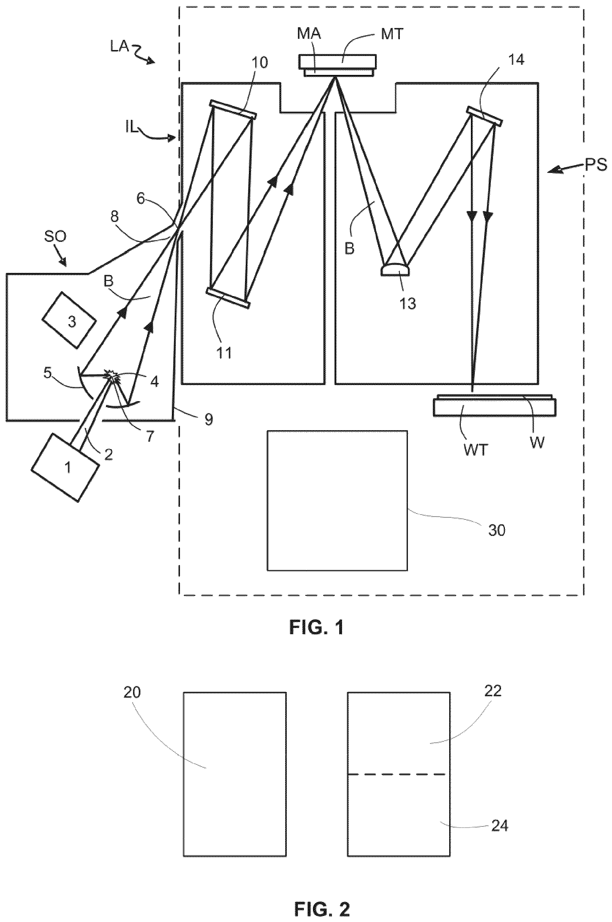

Fig. 1 schematically depicts a lithographic system including a substrate storage system 30. The lithographic system comprises a radiation source SO and a lithographic apparatus LA. The radiation source SO is configured to generate an extreme ultraviolet (EUV) radiation beam B. The lithographic apparatus LA comprises an illumination system IL, a support structure MT configured to support a patterning device MA (e.g. a mask or reticle), a projection system PS and a substrate table WT configured to support a substrate W. The illumination system IL is configured to condition the radiation beam B before it is incident upon the patterning device MA. The projection system PS is configured to project the radiation beam B (now patterned by the mask MA) onto the substrate W. The substrate W may include previously formed patterns. Where this is the case, the lithographic apparatus may align the patterned radiation beam B with a pattern previously formed on the substrate W.

The radiation source SO, illumination system IL, and projection system PS may all be constructed and arranged such that they can be isolated from the external environment. A gas at a pressure below atmospheric pressure (e.g. hydrogen) may be provided in the radiation source SO. A vacuum may be provided in illumination system IL and/or the projection system PS. A small amount of gas (e.g. hydrogen) at a pressure well below atmospheric pressure may be provided in the illumination system IL and/or the projection system PS.

The radiation source SO shown in Fig. 1 is of a type which may be referred to as a laser produced plasma (LPP) source). A laser 1, which may for example be a CO2 laser, is arranged to deposit energy via a laser beam 2 into a fuel, such as tin (Sn) which is provided from a fuel emitter 3. Although tin is referred to in the following description, any suitable fuel may be used. The fuel may for example be in liquid form, and may for example be a metal or alloy. The fuel emitter 3 may comprise a nozzle 15 configured to direct tin, e.g. in the form of droplets, along a trajectory towards a plasma formation region 4. The laser beam 2 is incident upon the tin at the plasma formation region 4. The deposition of laser energy into the tin creates a plasma 7 at the plasma formation region 4. Radiation, including EUV radiation, is emitted from the plasma 7 during de-excitation and recombination of ions of the plasma.

The EUV radiation is collected and focused by a near normal incidence radiation collector 5 (sometimes referred to more generally as a normal incidence radiation collector). The collector 5 may have a multilayer structure which is arranged to reflect EUV radiation (e.g. EUV radiation having a desired wavelength such as 13.5 nm). The collector 5 may have an elliptical configuration, having two ellipse focal points. A first focal point may be at the plasma formation region 4, and a second focal point may be at an intermediate focus 6, as discussed below.

The laser 1 may be separated from the radiation source SO. Where this is the case, the laser beam 2 may be passed from the laser 1 to the radiation source SO with the aid of a beam delivery system (not shown) comprising, for example, suitable directing mirrors and/or a beam expander, and/or other options. The laser 1 and the radiation source SO may together be considered to be a radiation system.

Radiation that is reflected by the collector 5 forms a radiation beam B. The radiation beam B is focused at point 6 to form an image of the plasma formation region 4, which acts as a Virtual radiation source for the illumination system IL. The point 6 at which the radiation beam B is focused may be referred to as the intermediate focus. The radiation source SO is arranged such that the intermediate focus 6 is located at or near to an opening 8 in an enclosing structure 9 of the radiation source.

The radiation beam B passes from the radiation source SO into the illumination system IL, which is configured to condition the radiation beam. The illumination system IL may include a facetted field mirror device 10 and a facetted pupil mirror device 11. The faceted field mirror device 10 and faceted pupil mirror device 11 together provide the radiation beam B with a desired cross-sectional shape and a desired angular distribution. The radiation beam B passes from the illumination system IL and is incident upon the patterning device MA held by the support structure MT. The patterning device MA reflects and patterns the radiation beam B. The illumination system IL may include other mirrors or devices in addition to or instead of the faceted field mirror device 10 and faceted pupil mirror device 11.

Following reflection from the patterning device MA the patterned radiation beam B enters the projection system PS. The projection system PS comprises a plurality of mirrors 13, 14 which are configured to project the radiation beam B onto a substrate W held by the substrate table WT. The projection system PS may apply a reduction factor to the radiation beam B, forming an image with features that are smaller than corresponding features on the patterning device MA. A reduction factor of four may, for example, be applied. Although the projection system PS has two mirrors 13, 14 in Fig. 1, the projection system PS may include any number of mirrors (e.g. six mirrors).

The radiation sources SO shown in Fig. 1 may include components which are not illustrated. For example, a spectral filter may be provided in the radiation source SO. The spectral filter may be substantially transmissive for EUV radiation but substantially blocking for other wavelengths of radiation such as infrared radiation.

As discussed above, some lithographic apparatus may be used to perform stitched lithographic exposures in which at least two sub-exposures take place on neighboring areas of the substrate W to image a desired area of the patterning device MA onto the substrate W. Fig. 2 schematically depicts a maximum image area 20 of a first lithographic apparatus compared with two maximum image areas 22, 24 of a second lithographic apparatus. In the example of Fig. 2, the maximum image area 22, 24 of the second lithographic apparatus is half of the maximum image area 20 of the first lithographic apparatus. Whereas the first lithographic apparatus required one exposure 20 to image the desired area onto the substrate, the second lithographic apparatus required two sub-exposures 22, 24 to image the same desired area onto the substrate. In the case of the second lithographic apparatus, a first sub-exposure 22 is performed using a first area of the patterning device then a second sub-exposure 24 is performed either using a different area of the patterning device or using a different patterning device. The second sub-exposure 24 takes place on a neighboring area of the substrate such that the image formed on the substrate is equivalent to the image 20 formed using the first lithographic apparatus. Other lithographic apparatus may have a smaller maximum image area than the second lithographic apparatus. For example, other lithographic apparatus may have a maximum image area that is a third of the maximum image area 20 of the first lithographic apparatus. In this case, three sub-exposures may be performed such that the image formed on the substrate is equivalent to the image 20 formed using the first lithographic apparatus.

More generally, stitching of two or more sub-exposures may be used when the chip structure to be projected has a size which is larger than what would normally fit within one exposure. For example, chip structures are known which cover a complete substrate. To cover such a large chip structure stitching of multiple sub-exposures may be applied.

After a lithographic exposure has been performed, the substrate may undergo resist processing which may, for example, include a baking process. In the case of a stitched exposure, the baking process is postponed until each sub-exposure has taken place across all target areas of the substrate. In some lithographic processes, the baking process may not begin until all substrates of a substrate lot (e.g. twenty-five substrates) have undergone the stitched exposure. If the baking process takes place for an entire lot of substrates, then long delays (e.g. between five and ten minutes) may arise between performing the first set of sub-exposures on the first substrate of the lot and performing the final set of sub-exposures on the final substrate of the lot. A delay between performing an exposure and baking the substrate may negatively affect the structures that are to be formed on the substrate due, at least in part, to interactions between the resist on the substrate and the ambient air in which the substrate is held.

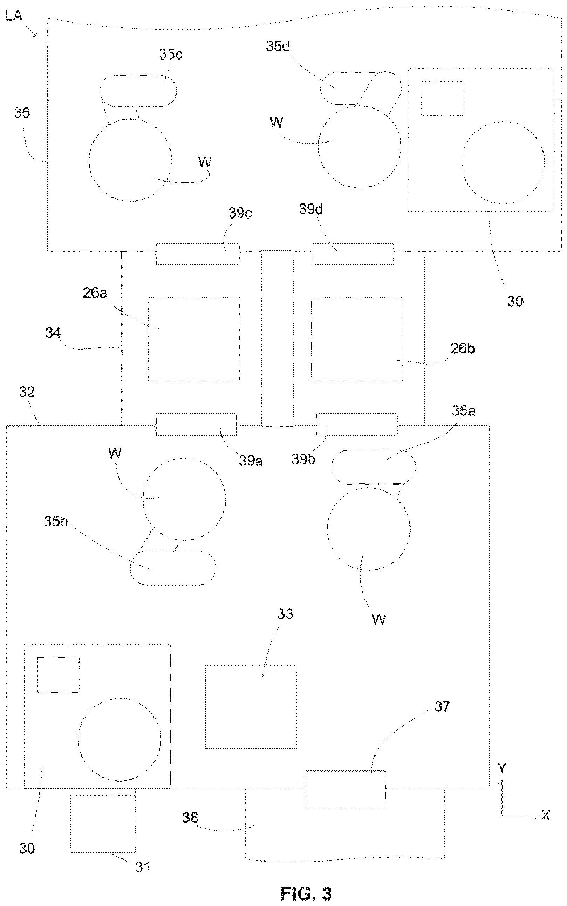

One method of reducing the negative effect associated with ambient air interacting with a lithographically exposed substrate before the substrate undergoes resist processing includes providing the lithographic apparatus with a substrate storage system for protecting lithographically exposed substrates from ambient air. Fig. 3 schematically depicts a view from above a portion of a lithographic apparatus LA having a substrate storage system 30. The portion of the lithographic apparatus LA comprises an atmospheric substrate handling module 32, a transition substrate handling module 34 and a vacuum substrate handling module 36. The atmospheric module 32 is configured to receive substrates W from a track (not shown) via a track interface 37 under cleanroom conditions (i.e. in ambient air having a controlled level of contaminants) and transfer the substrates W to the transition module 34. The transition module 34 is configured to receive a substrate W from the atmospheric module 32 under atmospheric conditions, generate a vacuum environment, and provide the substrate W to the vacuum module 36. The transition module 34 comprises doors 39a-d that are configured to form a seal when the transition module 34 converts its internal environment from atmospheric conditions to vacuum conditions and vice versa. The transition module 34 comprises stages 26a-b configured to hold substrates whilst the transition between atmospheric conditions and vacuum conditions takes place. The vacuum module 36 is configured to hold the substrate W under vacuum conditions whilst the substrate W is used in the lithographic apparatus LA (e.g. during measurement of the substrate and/or during lithographic exposure of the substrate).

The atmospheric module 32 may comprise a substrate measurement stage 33 that is configured to measure characteristics such as, for example, a position and/or a temperature of a substrate that is located on the substrate measurement stage 33. The substrate measurement stage 33 may be configured to perform additional functions such as, for example, to correct for position offsets of the substrate (e.g. in cylindrical polar coordinates) and/or to thermally condition the substrate to reach a desired temperature. A measurement stage 33 present in the atmospheric module 32 may be or comprise an atmospheric pre-aligner. The vacuum module 36 may also comprise a measurement stage (not shown) and/or pre-aligner. The atmospheric module 32 may comprise a track interface 37. The track interface 37 may be configured to provide an entrance to and/or exit from a track 38. The track interface 37 and the track 38 may comprise ingoing sections (not shown) for substrates entering the lithographic apparatus and outgoing sections (not shown) for substrates leaving the lithographic apparatus. For example, the track 38 may provide outgoing substrates to a resist processing apparatus (not shown) which may, for example, be configured to receive lithographically exposed substrates W and perform a baking process on the substrates. Additionally or alternatively the resist processing apparatus may be configured to coat substrates W with a layer of resist and provide the substrates to the ingoing sections of the track 38 and track interface 37 for re-entering the lithographic apparatus LA for a lithographic exposure. The atmospheric module 32 may comprise one or more store units (not shown) configured to receive incoming substrates from the ingoing section of the track interface 37 and/or provide outgoing substrates to the outgoing section of the track interface 37. The atmospheric module 32 may comprise one or more robotic arms 35a-b. The robotic arms 35a-b may be configured to collect substrates from and/or provide substrates to the one or more store units. The robotic arms 35a-b may be configured to provide substrates W to and/or receive substrates from the substrate carrier 31, the substrate storage system 30, the transition module 34 and the track interface 37. In general, the substrate carrier 31 is used for storing and transporting substrates for calibrations and test procedures rather than lithographic production. The robotic arms 35a-b may be configured to move substrates W between different parts of the atmospheric module 32 (e.g. moving substrates W between the substrate measurement stage 33 and the track interface 37).

The substrate storage system 30 may be an integral part of the lithographic apparatus LA. That is, the substrate storage system 30 may remain connected to the lithographic apparatus LA throughout operation of the lithographic apparatus LA (i.e. the substrate storage system 30 cannot be removed from the lithographic apparatus LA unless the lithographic apparatus is switched off). This is because the substrate storage system 30 is amongst components of the lithographic apparatus (e.g. robotic arms 35a-d) and it may not be safe to attempt to access the substrate storage system 30 during operation of the lithographic apparatus LA. In the example of Fig. 3, the substrate storage system 30 is an integral part of the atmospheric module 32. The substrate storage system 30 may be an integral part of the transition module 34, the vacuum module 36 or any other part of the lithographic apparatus LA.

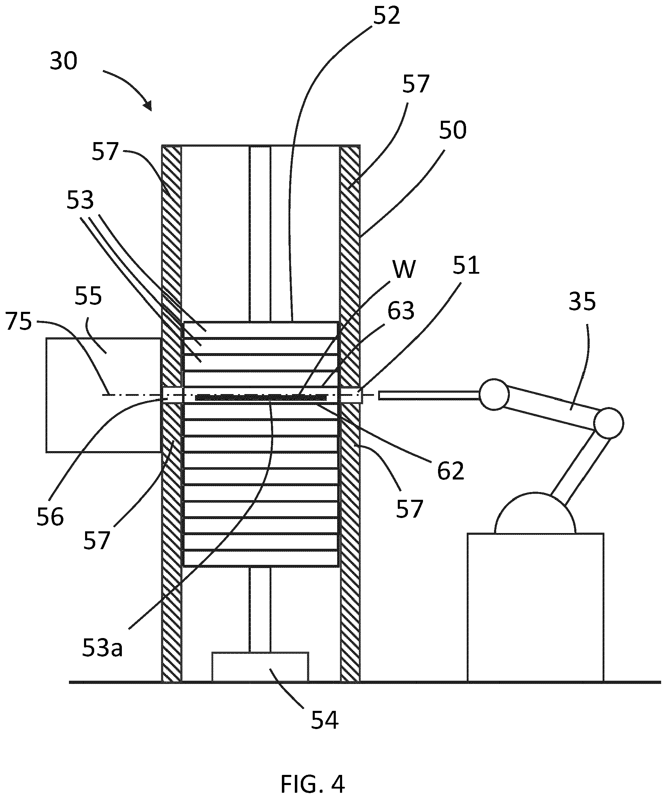

The substrate storage system 30 comprises a controllable environment for protecting a plurality of substrates from ambient air. The substrate storage system 30 may be configured to store at least ten or at least fifteen substrates as shown in the example of figure 4s. When the substrate storage system 30 is an integral part of the atmospheric module 32, the substrate storage system 30 may be provided with a gas delivery system configured to provide gas having a desired chemical composition and humidity. When the substrate storage system 30 is an integral part of the vacuum module 36, the substrate storage system 30 may be provided with a gas delivery system configured to provide gas having a desired Chemical composition and humidity.

In contrast to the substrate storage system 30, the substrate carrier 31 may not be an integral part of the lithographic apparatus LA because the substrate carrier 31 is temporarily connected to an external part of the lithographic apparatus LA and is configured to be easily attached and detached from the lithographic apparatus LA during operation of the lithographic apparatus LA. The substrate carrier 31 may, for example, comprise a front opening unified pod (FOUP). FOUPs are used to transport substrates between lithographic apparatus and resist processing apparatus. The internal environment of a FOUP 31 typically comprises ambient air. Ambient air is also present in the internal environment of the atmospheric module 32. Whilst the ambient air present in the substrate carrier 31 and the atmospheric module 32 may be filtered and/or otherwise "cleaned" for example to a cleanroom specification, the ambient air may still have a negative effect on substrates that have undergone a lithographic exposure but are yet to undergo another process, such as a baking process. The negative effects caused to lithographically exposed substrates by the ambient air may be due to, for example, undesirable humidity levels and/or an undesirable Chemical composition (e.g. an undesirable concentration of amines) of the ambient air. In contrast, the substrate storage system 30 comprises a controllable environment for protecting a plurality (e.g. at least eighteen) lithographically exposed substrates from ambient air. For example, the temperature, the humidity and/or the concentration of amines present in a gas provided to the substrate storage system 30 may be controlled.

Figure 4 discloses an embodiment of the substrate storage system 30.

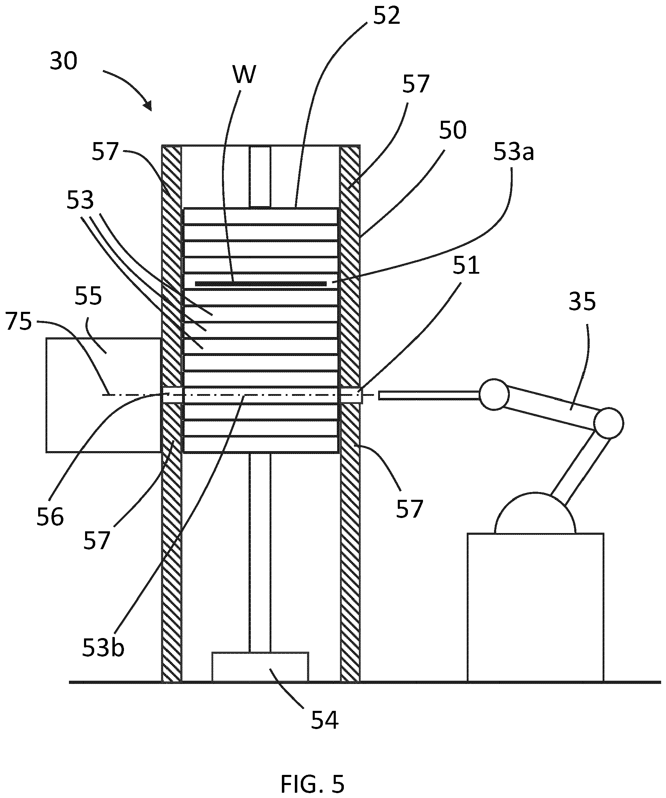

The substrate storage system 30 comprises an enclosure 50, a substrate loading port 51, and a substrate holder 52. The enclosure 50 is configured to form a closed environment in which substrates W may be stored. The enclosure 50 is for example a housing made of plate materials. The substrate holder 52 is configured to hold multiple substrates W. The substrate holder 52 comprises multiple holding locations 53, wherein each holding location 53 is configured to hold exactly one substrate W. In the embodiment of Figures 4 and 5, only one substrate W is stored in the substrate storage system 30. The substrate holder 52 is arranged to hold a stack of substrates W, wherein the stack is arranged vertically. The substrate holder 52 may for example comprise a plurality of cassettes, wherein each cassette is configured to receive and hold one individual substrate W. The cassettes may be stackable to create a column of holding locations 53 to support the multiple substrates of the stack of substrates W.

The substrate loading port 51 is provided to load a substrate into the enclosure 50 and/or to unload a substrate W from the enclosure 50. A robotic arm 35, which may for example be either one of the above mentioned robotic arms 35a and 35b, with a substrate gripper may be at least partially moved into the enclosure 50 via the substrate loading port 51 to load the substrate W in a loading position or to unload the substrate from the loading position. The substrate loading port 51 may be the only open connection between the interior and the exterior of the substrate storage system 30.

Figure 4 shows a substrate W loaded into the substrate storage system 30 at the loading position. In the example state of the substrate storage system 30 as shown in figure 4, a fifth holding location 53a of the plurality of holding locations 53 is arranged in the loading position to support the substrate W in this loading position.

The substrate storage system 30 comprises an actuator 54 to linearly move the substrate holder 52 in order to move each of the multiple substrates W between the loading position and at least one storage position spaced from the loading position. The actuator 54 may for example comprise a spindle that is configured to displace the substrate holder 52 in vertical direction between different positions.

Figure 5 shows the substrate storage system 30 of Figure 4, in which the substrate holder 52 has been moved upwards by suitable control of the actuator 54. In this position of the substrate holder 52, the fifth holding location 53a of the substrate holder 52 and the substrate W supported thereon are now arranged in a storage position spaced from the loading position shown in Figure 4. In this position of the substrate holder 52, the substrate W cannot be directly unloaded from the substrate storage system 30 by the robotic arm 35. In order to unload the substrate W from the substrate storage system 30, the substrate holder 52 first has to be placed back into the position shown in Figure 4, in which the fifth holding location 53a and the substrate W supported thereon is placed in the loading position and thus aligned with the substrate loading port 51. From this loading position, the substrate W can be unloaded from the fifth holding location 53a, and, when desired, a new substrate W can be loaded into the substrate storage system 30.

It is noted that in the embodiment of Figures 4 and 5 only one of the multiple holding locations 53 can be arranged in the loading position at the same time. The other holding locations 53 of the substrate holder 52 will be arranged in a storage position. For example, in Figure 4, the fifth holding location 53a is located in the loading position and all other holding locations 53 are positioned in a storage position. In Figure 5, the fifth holding location 53a is located in a storage position, while a twelfth holding location 53b of the multiple holding locations is arranged in the loading position. When the fifth holding location 53a or one of the other holding locations 53 is arranged in the loading position, the twelfth holding location 53b will be in a storage position. Each of the storage positions is spaced from the loading position of a respective substrate W.

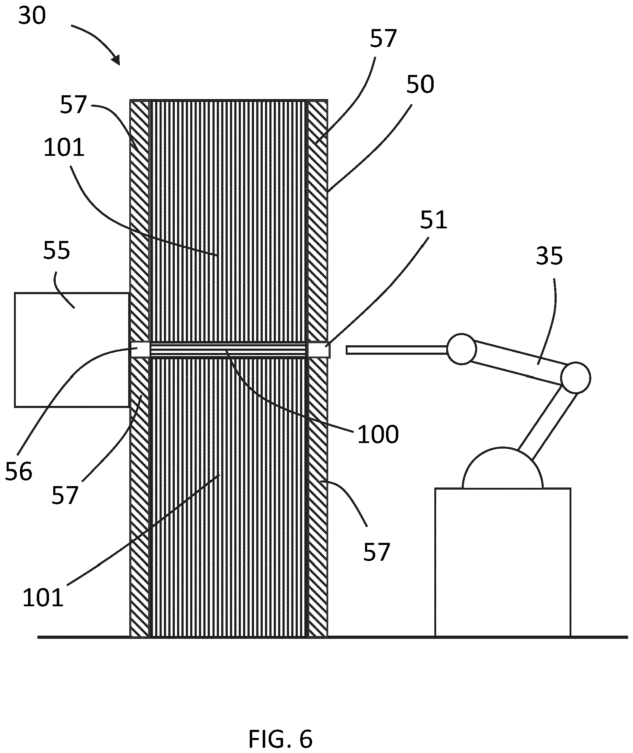

Figure 6 shows the substrate storage system 30 of Figures 4 and 5 without the substrate holder 52 and associated actuator 54. In figure 6, the location of the loading position 100, indicated by a horizontal hatching, and the locations of storage positions 101, indicated by vertical hatchings, are depicted. This makes clear that the location of the loading position and storage positions is independent from the actual position of the substrate holder 52. The loading position 100 is always aligned with the substrate loading port 51 and the purging gas inlet 56. Correspondingly, the locations of the storage positions 101 are not aligned with the substrate loading port 51 and the purging gas inlet 56.

An advantage of the substrate storage system 30 of Figures 4 and 5 is that the substrates W in the substrate storage system 30 are properly protected from the environment since the enclosure 50 provides a suitable separation between the interior and the exterior of the enclosure 50. Substrates can only be introduced into the enclosure or taken out of the enclosure via the substrate loading port 51. It is noted that the embodiment of Figures 4 and 5 comprises one substrate loading port 51. In alternative embodiments, the substrate storage system may comprise two or more substrate loading ports 51. For example, a first substrate loading port 51 is used for loading of substrates and a second substrate loading port 51 is used for unloading of substrates. For each of the substrate loading ports and associated loading position within the enclosure a purging system may be provided.

In an embodiment, at least during an idle or waiting time of the substrate storage system 30, a holding location 53 which is in the loading position may be left empty so that all the substrates W stored in the storage system 30 are positioned in a storage position protected from the environment during said idle or waiting time.

The substrate storage system 30 comprises a purging system 55 to purge the substrate W when located in the loading position. The purging system 55 is thus arranged to mainly purge a substrate W when arranged in the loading position. Substrates W arranged in any of the storage positions will be mainly non-purged. The loading position may be continuously purged or only when a substrate W is in the loading position.

By only purging the substrate W in the loading position, the purging system 55 requires a smaller volume of purging gas compared to a purging system in which all holding locations 53 of the substrate holder 52 are simultaneously and continuously purged.

The purging system 55 shown in the embodiment of Figures 4 and 5 comprises a purging gas inlet 56 to introduce purging gas towards the loading position and a purging gas outlet to allow purging gas to leave the loading position. The purging gas outlet is formed by the substrate loading port 51 such that purging gas can leave the enclosure 50 via the substrate loading port 51.

The purging gas may for example be clean air, dry air, nitrogen or an inert gas. The purging gas may have other chemical/physical properties than the gas outside the substrate storage system 30, for example, in order to condition the substrates W. For example when nitrogen purging or more dry or humid conditions in the substrate storage system 30 are desired.

The purging gas inlet 56, the loading position and the substrate loading port 51 are arranged in a single plane 75. In the embodiment of Figures 4 and 5 the purging gas inlet 56, the loading position and the substrate loading port 51 are arranged at the same height. Further, the purging gas inlet 56 is arranged at a first side of the loading position and the substrate loading port is arranged at a second side of the loading position, wherein the first side is opposite to the second side. By arranging the purging gas inlet 56 and the substrate loading port 51 at opposite sides of the loading position, the purging gas can flow in a single direction along the substrate W without the need to follow a curve. This configuration may improve the creation of a homogeneous flow and thereby refreshment of purging gas around the substrate in the loading position. Said single direction flow may reduce the residence time of the purging gas around the substrate. Reduced residence time of the purging gas around the substrate also reduces particle and molecule contamination risk of the substrate.

To prevent or at least reduce the flow of purging gas towards any of the storage locations, the purging system 55 comprises flow barriers 57 that prevent purging gas flowing between the substrate holder 52 and the enclosure 50 toward the storage positions. The flow barriers 57 may be any construction or material that may substantially block air flow from the purging gas inlet 56 to the storage positions and/or from the storage positions to the substrate loading port 51. The flow barriers 57 may also be at least partially formed by the enclosure 50 itself.

In an embodiment, the substrate storage system 30 may be arranged to purge the storage positions adjacent to the loading position. For example, the flow barriers 57 may be adapted to purge the storage positions directly adjacent to the loading position, such as one storage position above and one storage position below the loading position. This purging of adjacent loading positions may be carried out at the same time as purging of the loading position. The flow rate of purging gas in the adjacent storage positions may be lower than the flow rate of purging gas in the loading position. This difference in flow rate may for example be defined by the structure of the flow barriers.

In an embodiment, there may be provided an additional purging gas inlet and/or purging gas outlet to intermittently purge the complete interior of the enclosure 50, for example when no substrates are present in the substrate holder 52. Even though flow barriers 57 are provided, it is still possible that gas leaks towards the storage positions occurs. It may be beneficial to purge occasionally the enclosure to remove any contaminations present in this gas.

Each of the multiple holding locations 53 is arranged within a guiding channel in the substrate holder 52 arranged to guide purging gas along the substrate W held in a respective one of the multiple holding locations 53 and positioned in the loading position. The substrate holder 52 is configured such that a guiding channel is formed to guide purging gas through the substrate holder 52 along the substrate held in the loading position in the substrate holder 52.

The purging gas may flow along the top surface and the bottom surface of the substrate W in the loading position such that the purging gas may take along any particles present above and/or below the substrate W. The guiding channel may for example be formed by four walls enclosing the holding locations at four sides, wherein the two remaining sides are open and aligned with the purging gas inlet 56 and the substrate loading port 51, respectively. In such construction the guiding channel is formed as a closed sleeve that guides purging gas through a straight channel from the purging gas inlet 56 to the substrate loading port 51. The inner surfaces of the guiding channel and/or closed sleeve may be smooth to avoid or reduce turbulence in the laminar flow of purging gas.

Figure 6 shows a top view of a substrate W positioned in the loading position on the substrate holder 52.

The purging system 55 comprises a pump device 61 arranged to pump purging gas. In this embodiment the pump device 61 is located relatively close to the substrate holder 52, but in practice the pump device 61 may be arranged further away from the substrate holder 52. There may also be provided a single pump device 61 that is configured to provide purging gas for multiple locations to be purged, for example multiple loading positions in the substrate holder 52.

The bottom wall 62 and top wall 63, shown in Figure 4, and the side walls 64, shown in Fig.6, are arranged around the fifth holding location 53a to form the closed sleeve to guide the purging gas from the purging gas inlet 56 to the substrate loading port 51. Due to this closed sleeve with substantially constant cross section over its length, a laminar flow, as indicated with arrows in Figure 6, can be created to purge the substrate W.

The purging system 55 further comprises a filter device 58 upstream of the purging gas inlet 56 to filter the purging gas before it is guided to the substrate holder 52. The filter device 58 comprises one or more filters 59 and an electrically conductive mesh 60 placed downstream of the one or more filters 59, i.e. between the one or more filters 60 and the purging gas inlet 56. The electrically conductive mesh 60 is configured to attract and hold any particles that are able to pass the one or more filters 59. Typically the one or more filters 59 will charge the particles that are able to pass the one or more filters 59. This charge can be used to attract the particles by the electrically conductive mesh 60.

The electrically conductive mesh 60 may be provided with a charge offset to improve the attraction of the particles charged by the one or more filters. Although generally it is undesirable to provide one or more filters that may electrostatically charge particles, the charge of the particles is in this filter device 58 effectively used to catch particles out of the flow of purging gas before the purging gas is guided to the substrate holder.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Although specific reference may have been made above to the use of embodiments of the invention in the context of optical lithography, it will be appreciated that the invention, where the context allows, is not limited to optical lithography and may be used in other applications, for example imprint lithography.

Aspects of the present disclosure are described in the following numbered clauses:
1. A substrate storage system comprising:
   an enclosure;
   a substrate loading port to load a substrate into and/or unload a substrate from a loading position within the enclosure,
   a substrate holder to hold a substrate within the enclosure, wherein the substrate holder is configured to move the substrate between the loading position and at least one storage position spaced from the loading position,
   a purging system to mainly purge the substrate when located in the loading position, and wherein the at least one storage position is a mainly non-purged space.
2. The substrate storage system of clause 1, wherein the purging system comprises a purging gas inlet to introduce purging gas towards the loading position and a purging gas outlet to allow purging gas to leave the loading position, wherein the purging gas outlet comprises the substrate loading port.
3. The substrate storage system of clause 2, wherein the purging gas inlet, the loading position and the substrate loading port are arranged in a single plane.
4. The substrate storage system of clause 2 or 3, wherein the purging gas inlet is arranged at a first side of the loading position and wherein the substrate loading port is arranged at a second side of the loading position, wherein the first side is opposite to the second side.
5. The substrate storage system of any of the clauses 1-4, wherein the substrate holder is configured to hold multiple substrates, wherein the substrate holder is movable to move each of the multiple substrates between the loading position and at least one storage position spaced from the loading position.
6. The substrate storage system of clause 5, wherein the substrate holder is arranged to hold a stack of substrates,
7. The substrate storage system of clause 5 or 6, wherein the substrate holder comprises a plurality of cassettes, wherein each cassette is configured to receive and hold one substrate.
8. The substrate storage system of any of the clauses 5-7, wherein the substrate holder comprises multiple holding locations each configured to hold exactly one substrate of the plurality of substrates.
9. The substrate storage system of clause 8, wherein the substrate storage system comprises an actuator to move the substrate holder to arrange a selected one of the multiple holding locations in the loading position.
10. The substrate storage system of clause 8 or 9, wherein each of the multiple holding locations is arranged within a guiding channel, wherein the guiding channel is arranged to guide purging gas along the substrate held in a respective one of the multiple holding locations and positioned in the loading position.
11. The substrate storage system of clause 10, wherein the guiding channel is shaped to guide purging gas above and below the substrate held in a respective one of the multiple holding locations and positioned in the loading position.
12. The substrate storage system of clause 10 or 11, wherein the guiding channel is formed as a closed sleeve between a purging gas inlet and a purging gas outlet of the purging system.
13. The substrate storage system of any of the clauses 1-12, wherein the purging system comprises a filter device to filter purging gas before purging the substrate located in the loading position, wherein the filter device comprises one or more filters and an electrically conductive mesh placed downstream of the one or more filters.
14. The substrate storage system of clause 13, wherein the electrically conductive mesh is provided with a charge offset to attract particles charged by the one or more filters.
15. The substrate storage system of any of the clauses 1-14, wherein the substrate loading port is arranged to allow a gripper to at least partially enter the enclosure to load a substrate into and/or unload a substrate from the loading position within the enclosure.
16. The substrate storage system of any of the clauses 1-15, wherein the purging system comprises one or more flow barriers that prevent purging gas flowing along the at least one storage position.
17. A substrate handling apparatus comprising the substrate storage system of any of the preceding clauses.
18. The substrate handling apparatus of clause 17, wherein the substrate handling apparatus is a lithographic apparatus.
19. A method of temporarily storing a substrate in the substrate storage system of any of the clauses 1-16, comprising the steps of:
   loading the substrate through the substrate loading port in the loading position onto the substrate holder,
   moving the substrate holder to arrange the substrate in the at least one storage position,
   moving the substrate holder to arrange the substrate back in the loading position,
   unloading the substrate through the substrate loading port from the loading position,
   wherein the method comprises during at least loading and unloading of the substrate mainly purging of the substrate in the loading position, and
   wherein the method comprises mainly non-purging of the substrate in the storage position.
20. A method comprising projecting a patterned beam of radiation onto a substrate, comprising the steps of:
   carrying out a first projecting step of projecting a patterned beam of radiation onto the substrate, wherein the patterned beam of radiation is patterned with a first patterning device,
   temporarily storing the substrate in the substrate storage system of any of the clauses 1-16, and
   carrying out a second projecting step of projecting a patterned beam of radiation onto the substrate, wherein the patterned beam of radiation is patterned with a second patterning device.
21. The method of clause 20, wherein the second projecting step comprises stitching of a pattern of the second patterning device with a pattern of the first patterning device projected during the first projecting step.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

## Claims

1. A substrate storage system comprising:
an enclosure;
a substrate loading port to load a substrate into and/or unload a substrate from a loading position within the enclosure,
a substrate holder to hold a substrate within the enclosure, wherein the substrate holder is configured to move the substrate between the loading position and at least one storage position spaced from the loading position,
a purging system to mainly purge the substrate when located in the loading position, and
wherein the at least one storage position is a mainly non-purged space.

2. The substrate storage system of claim 1, wherein the purging system comprises a purging gas inlet to introduce purging gas towards the loading position and a purging gas outlet to allow purging gas to leave the loading position, wherein the purging gas outlet comprises the substrate loading port.

3. The substrate storage system of claim 2, wherein the purging gas inlet, the loading position and the substrate loading port are arranged in a single plane.

4. The substrate storage system of claim 2 or 3, wherein the purging gas inlet is arranged at a first side of the loading position and wherein the substrate loading port is arranged at a second side of the loading position, wherein the first side is opposite to the second side.

5. The substrate storage system of any of the claims 1-4, wherein the substrate holder is configured to hold multiple substrates, wherein the substrate holder is movable to move each of the multiple substrates between the loading position and at least one storage position spaced from the loading position.

6. The substrate storage system of claim 5, wherein the substrate holder is arranged to hold a stack of substrates,

7. The substrate storage system of claim 5 or 6, wherein the substrate holder comprises a plurality of cassettes, wherein each cassette is configured to receive and hold one substrate.

8. The substrate storage system of any of the claims 5-7, wherein the substrate holder comprises multiple holding locations each configured to hold exactly one substrate of the plurality of substrates, preferably wherein the substrate storage system comprises an actuator to move the substrate holder to arrange a selected one of the multiple holding locations in the loading position.

9. The substrate storage system of claim 8, wherein each of the multiple holding locations is arranged within a guiding channel, wherein the guiding channel is arranged to guide purging gas along the substrate held in a respective one of the multiple holding locations and positioned in the loading position,
preferably wherein:
- the guiding channel is shaped to guide purging gas above and below the substrate held in a respective one of the multiple holding locations and positioned in the loading position; and/or
- the guiding channel is formed as a closed sleeve between a purging gas inlet and a purging gas outlet of the purging system.

10. The substrate storage system of any of the claims 1-9, wherein the purging system comprises a filter device to filter purging gas before purging the substrate located in the loading position, wherein the filter device comprises one or more filters and an electrically conductive mesh placed downstream of the one or more filters,
preferably wherein the electrically conductive mesh is provided with a charge offset to attract particles charged by the one or more filters.

11. The substrate storage system of any of the claims 1-10, wherein the substrate loading port is arranged to allow a gripper to at least partially enter the enclosure to load a substrate into and/or unload a substrate from the loading position within the enclosure.

12. The substrate storage system of any of the claims 1-11, wherein the purging system comprises one or more flow barriers that prevent purging gas flowing along the at least one storage position.

13. A substrate handling apparatus comprising the substrate storage system of any of the preceding claims,
preferably wherein the substrate handling apparatus is a lithographic apparatus.

14. A method of temporarily storing a substrate in the substrate storage system of any of the claims 1-12, comprising the steps of:
loading the substrate through the substrate loading port in the loading position onto the substrate holder,
moving the substrate holder to arrange the substrate in the at least one storage position,
moving the substrate holder to arrange the substrate back in the loading position,
unloading the substrate through the substrate loading port from the loading position,
wherein the method comprises during at least loading and unloading of the substrate mainly purging of the substrate in the loading position, and
wherein the method comprises mainly non-purging of the substrate in the storage position.

15. A method comprising projecting a patterned beam of radiation onto a substrate, comprising the steps of:
carrying out a first projecting step of projecting a patterned beam of radiation onto the substrate, wherein the patterned beam of radiation is patterned with a first patterning device,
temporarily storing the substrate in the substrate storage system of any of the claims 1-12, and
carrying out a second projecting step of projecting a patterned beam of radiation onto the substrate, wherein the patterned beam of radiation is patterned with a second patterning device, preferably wherein the second projecting step comprises stitching of a pattern of the second patterning device with a pattern of the first patterning device projected during the first projecting step.
